# EUROPÄISCHE PATENTSCHRIFT

(11) **EP 3 949 024 B1**
(45) Veröffentlichungstag und Bekanntmachung des Hinweises auf die Patenterteilung: **01.05.2024**
(21) Anmeldenummer: 20717081.2
(22) Anmeldetag: 16.03.2020
(51) Int. Cl.: H05K 3/36, H01R 12/71, H01R 12/73, H01R 13/24, H05K 1/11, H05K 1/14, H05K 3/32, H01R 12/70

(54) **STECKVERBINDER**
PLUG CONNECTOR
CONNECTEUR ENFICHABLE

(30) Priorität: 25.03.2019 DE 102019107573
(43) Veröffentlichungstag der Anmeldung: 09.02.2022
(73) Patentinhaber: HARTING Electric Stiftung & Co. KG, 32339 Espelkamp (DE)
(72) Erfinder: FRIESEN, Markus, 32339 Espelkamp (DE); RIECHMANN, Till, 32339 Espelkamp (DE); LOSKE, Felix., 32339 Espelkamp (DE); HEILE, Inga, 32339 Espelkamp (DE); VOLLMER, Christian, 32339 Espelkamp (DE)
(86) Internationale Anmeldenummer: PCT/DE2020/100201
(87) Internationale Veröffentlichungsnummer: WO 2020/192836

(56) Entgegenhaltungen:
- DE-A1-102016 205 939
- FR-A1- 2 709 850
- FR-A1- 2 775 373
- JP-A- S6 116 485
- JP-U- S 639 772
- US-A1- 2006 286 858
- US-A1- 2013 319 739
- US-A1- 2014 335 706
- US-A1- 2015 099 398
- US-B1- 6 220 871

## Beschreibung

Die Erfindung betrifft einen Steckverbinder und insbesondere einen Leiterplattensteckverbinder, sowie eine mit einem Steckverbinder versehene Leiterplatte.

Leiterplattensteckverbinder werden zur elektrischen Kontaktierung einer Leiterplatte benötigt.

Zur elektrischen Verbindung eines Steckverbinders mit einer Leiterplatte wird der Steckverbinder dabei auf die Leiterplatte aufgesteckt. Hierzu sind eine Vielzahl von Steckverbinderlösungen bekannt, bei denen ein Stecksockel oder eine Steckleiste auf der Leiterplatte montiert ist, in die ein entsprechend geformter Gegenstecker eingesteckt wird.

Eine direkte Verbindung des Steckverbinders mit der Leiterplatte findet dabei jedoch regelmäßig nicht statt. Um den Steckverbinder mit der Leiterplatte elektrisch zu verbinden, wird der Steckverbinder im Allgemeinen in eine mit der Leiterplatte elektrisch verbundene Grundleiste eingesteckt und mit der Steckleiste über Rastvorrichtungen verrastet.

### Stand der Technik

Aus der FR 2 775 373 A1 ist ein Verbinder für eine Chipkarte mit mindestens einem elektrischen Kontaktelement bekannt. Das Kontaktelement umfasst ein starres massives leitfähiges Element, das in einem isolierenden Käfig gehalten wird. Der Käfig weist eine ersten Öffnung auf, die es ermöglicht, dass ein Abschnitt des massiven leitfähigen Elements zur Bereitstellung eines elektrischen Kontakts aus dem Käfig herausragt. Der Käfig weist ausserdem eine zweite Öffnung zur Bereitstellung elektrischer Kontakte mit einem Leiter eines Trägerelements des Verbinders oder mit einem Leiter auf, der elektrisch mit einem Leiter des Trägerelements des Verbinders verbunden ist. Das massive leitfähige Element ist kugelförmig oder im Wesentlichen kugelförmig ausgebildet. Das starre massive leitfähige Element liegt unter der Wirkung eines elastischen Rückstellelements des Kontaktelements an einem Umfang der ersten Öffnung des Käfigs an, so dass ein Teil des starren leitfähigen massiven Elements aus dem Käfig herausragt.

Aus der US 2006/0286858 A1 ist eine Verbindungsstruktur für eine Leiterplattenanordnung bekannt, die eine hochdichte Integration ermöglichen soll. Ein flexibler gedruckter Schaltkreis enthält einen freiliegenden Leiterabschnitt mit einem isolierenden Substrat und einer Verstärkungsplatte, die mit diesem Substrat über ein elastisches Element gestapelt ist. Leiter des freiliegenden Leiterabschnitts weisen jeweils einen auf einer Oberfläche des isolierenden Substrats gebildeten Vorsprung auf. Der freiliegende Leiterabschnitt ist in der Dickenrichtung, in der das Substrat und die Verstärkungsplatte gestapelt sind, elastisch verformbar ausgebildet. Eine innere Schicht und eine erste und zweite äußere Schicht der Leiterplattenanordnung sind zu der Leiterplattenanordnung derart gestapelt, dass die äußeren Schichten die innere Schicht einschließen. Die innere Schicht weist eine Ausnehmung mit einer Einführöffnung auf. Als durchgehende Löcher ausgebildete Anschlüsse sind auf einer Seite der Ausnehmung der ersten äußeren Schicht ausgebildet. Wenn der flexible gedruckte Schaltkreis in die Einführöffnung der Ausnehmung eingeführt wird, passen die Vorsprünge des flexiblen gedruckten Schaltkreises von innerhalb der Einführöffnung unter Druck in die Anschlüsse.

Aus der US 2013/0319739 A1 ist Federfinger-Verbindungssystem mit einem Stecker und einer Buchse bekannt. Nach einer Ausführung weist der Stecker Federfingerkontakte zur Übertragung von elektrischen Signalen auf. Die Buchse weist einen Hohlraum zur Aufnahme des Steckers auf, wobei der Hohlraum mit Techniken zur Herstellung von Leiterplatten bereitgestellt werden kann. Nach einer Ausführung kann der Hohlraum zumindest teilweise in einer Vorimprägnierungsschicht gebildet werden und eine erste und eine zweite Schicht können über und unter der Vorimprägnierungsschicht angeordnet werden. Nach einer Ausführung können Kontakte auf der ersten Schicht angeordnet sein, um die Federfingerkontakte zu kontaktieren, wenn der Stecker in den Hohlraum eingeführt wird. Nach einer anderen Ausführung können Kontakte sowohl auf der ersten als auch auf der zweiten Schicht angeordnet sein. Nach einer weiteren Ausführung kann der Hohlraum derart ausgebildet sein, dass er die Ausrichtung der Kontakte zu den Federfingerkontakten des Steckers leitet, wenn der Stecker in den Hohlraum der Buchse eingeführt wird.

Aus der US 6,220,871 B1 ist ein elektrischer Verbinder bekannt, der zur Verbindung jeweils mehrerer zu kontaktierender elektrischer Kontakte einen ersten und zweiten Verbinder umfasst. Eine Leiterplatte des zweiten Verbinders trägt dessen elektrische Kontaktelemente und ist mit Schlitzen ausgebildet, die die jeweiligen elektrischen Kontaktelemente eng umgeben. Vorzugsweise besteht die Leiterplatte aus einer ersten Platte, die mit den oben beschriebenen Schlitzen ausgebildet ist, und aus einer zweiten Platte, die mit einer Öffnung ausgebildet ist, die eine Fläche aufweist, die der gesamten Fläche der ersten Platte entspricht, die mit den elektrischen Kontaktelementen versehen ist. Alternativ werden kleine zungenförmige bewegliche Teile, die die elektrischen Kontakte des zweiten Verbinders tragen, zuvor um einen Winkel α zu den elektrischen Kontakten des ersten Verbinders geneigt, und die elektrischen Kontakte des zweiten Verbinders werden auf der gegenüberliegenden Seite um einen Winkel β geneigt, wenn der erste und der zweite Verbinder vollständig verbunden sind, wobei für die Winkel die Beziehung α > β gilt. Auf diese Weise ist der elektrische Verbinder kompakt und derart ausgebildet ist, dass jede falsche Verbindung zwischen den elektrischen Kontaktelementen des ersten und des zweiten Verbinders verhindert wird und erforderliche Impedanzeigenschaften sichergestellt sind, selbst wenn Höhenunterschiede zwischen den elektrischen Kontakten des ersten Steckers bestehen.

US 2015/099398 A1 offenbart ein Verbinder zur elektrischen Verbindung mit einem Randstecker, um eine Stromversorgungseinrichtung und eine Kommunikationseinrichtung zu verbinden. Der Verbinder umfasst zwei PCB-Segmente. Eines oder beide Segmente umfassen elektrische Pads für Kontakte mit entsprechenden Pads auf dem Randstecker, und die Segmente sind so ausgerichtet, dass die Flächen, die die Pads tragen, nach innen zeigen. Zwischen den äußeren Segmenten befindet sich ein Abstandshalter, der sie etwa um die Breite einer Leiterplatte auseinanderhält. Die Lötaugen sind in der gleichen Weise angeordnet wie die entsprechenden Lötaugen des Gegensteckers, mit Lücken dazwischen. Innerhalb der Lücken können Schlitze in die Leiterplatte geschnitten werden, um die Elastizität am Ende der Pads zu erhöhen.

FR 2 709 850 A1 offenbart eine Kontaktfedervorrichtung zur elektrischen Kontaktierung der Kontaktflächen einer zusammen mit einem Kontaktträger eingeführten Karte, bei der in einer zwischen Kontakten des Kontaktträgers und einem Freiraum liegenden Wand, die zur Aufnahme des die Kontaktflächen enthaltenden Kartenquerschnitts bestimmt ist, Ausnehmungen vorgesehen sind, in die elastische Kontaktelemente eingesetzt sind, die einerseits den Kontakt mit den Kontakten des Kontaktträgers herstellen und andererseits in den Freiraum hineinragen, sowie eine Ausnehmung der Wand, die eine Kartenbremse enthält.

Aus der DE 43 12 091 C2 ist ein Leiterplattensteckverbinder zur Verbindung einer Leiterplatte mit einem Stecker bekannt, wobei jeweils ein Leiterbahnanschluss der Leiterplatte mit der jeweiligen Kontaktfeder des Steckers einen elektrischen Kontakt herstellt. Ein Steckergehäuse weist eine Zwischenwand auf, die senkrecht zur Richtung steht, in der Leiterplatte und Stecker verbunden werden, und in der eine Einstecköffnung ausgebildet ist.

Ein Führungsgehäuse ist zur Aufnahme des Leiterplattensteckbereichs mit seiner offenen Seite an der Einstecköffnung der Zwischenwand angeordnet, wobei das Führungsgehäuse Anschlussöffnungen zur Verbindung der Kontaktfedern mit den Leiterbahnen aufweist. Zum Führen der Kontaktfedern zwischen den jeweiligen Anschlussöffnungen beim Einstecken sind an dem Führungsgehäuse Führungsrippen vorgesehen.

Der von der DE 43 12 091 C2 vorgeschlagene Leiterplattensteckverbinder ist insbesondere mit seinem Steckergehäuse und seinem Führungsgehäuse nachteilhaft ausgedehnt in seiner Bauform und aufwendig in seiner Herstellung.

### Aufgabenstellung

Die Aufgabe der Erfindung besteht darin, einen kompakten Steckverbinder und insbesondere einen Leiterplattensteckverbinder anzugeben, der für viele Anwendungen geeignet ist, und der einfach und kostengünstig hergestellt werden kann. Dabei ist weitere Aufgabe der Erfindung eine mit einem Steckverbinder versehene Leiterplatte bereitzustellen.

Die Aufgabe wird durch die kennzeichnenden Merkmale des unabhängigen Anspruchs gelöst.

Vorteilhafte Ausführungen der Erfindung sind in den Unteransprüchen und/oder der nachfolgenden Beschreibung angegeben.

Die vorliegende Erfindung betrifft insbesondere einen ersten Steckverbinder zur Bereitstellung einer elektrischen Verbindung eines Leiterbahnanschlusses einer Leiterplatte mit einem Leiterbahnanschluss einer zu kontaktierenden Leiterplatte, wobei die erste Leiterplatte geeigneter Weise Bestandteil des ersten Steckverbinders ist.

Der erste Steckverbinder weist einen Steckbereich zum Stecken der zu kontaktierenden Leiterplatte in den ersten Steckverbinder auf, wobei sich der Steckbereich parallel zu der ersten Leiterplatte erstreckt.

Mit den vorstehenden Merkmalen ist vorteilhaft die Möglichkeit geschaffen, eine elektrische Verbindung der vorstehenden Leiterbahnanschlüsse bereitzustellen, wobei bei deren Leiterplatten parallel zueinander angeordnet sind. Auf diese Weise kann der erste Steckverbinder besonders kompakt ausgebildet werden, was außerdem dadurch begünstigt wird, dass die erste Leiterplatte Bestandteil des ersten Steckverbinders ist.

Zur Bereitstellung der elektrischen Verbindung des Leiterbahnanschlusses der ersten Leiterplatte mit dem Leiterbahnanschluss der zu kontaktierenden Leiterplatte ist in dem ersten Steckverbinder insbesondere an dem Leiterbahnanschluss der ersten Leiterplatte ein Kontaktelement und ein Federelement vorgesehen.

Der Steckbereich, das Kontaktelement und das Federelement sind dabei derart ausgebildet und angeordnet, dass die in den Steckbereich gesteckte zu kontaktierende Leiterplatte parallel zu der ersten Leiterplatte angeordnet ist, und über das Kontaktelement und das Federelement eine elektrische Verbindung des Leiterbahnanschlusses der ersten Leiterplatte mit dem Leiterbahnanschluss der zu kontaktierenden Leiterplatte bereitgestellt ist.

Wie vorstehend gesagt, gestattet ein erster Steckverbinder mit den vorstehenden Merkmalen eine besonders kompakte Bauform des Steckverbinders, die für viele Anwendungen wünschenswert ist.

Das Kontaktelement und das Federelement können geeigneter Weise außerdem derart ausgebildet und angeordnet sein, dass beim Einstecken der zu kontaktierenden Leiterplatte in den Steckbereich eine dabei parallel zu der ersten Leiterplatte wirkende Kraft eine derart senkrecht zu der ersten Leiterplatte und der zu kontaktierenden Leiterplatte wirkende Kraft auslöst, dass das Kontaktelement zwischen die parallel zueinander angeordneten Leiterplatten geklemmt ist. Auf diese Weise kann ein vorteilhaft besonders zuverlässiger elektrischer und mechanischer Kontakt des Kontaktelements und des Federelements mit den genannten Leiterbahnanschlüssen der Leiterplatten bereitgestellt werden.

Der Steckbereich ist eine in einer zweiten Kunststoffplatte ausgebildete Ausnehmung, wobei die zweite Kunststoffplatte dabei geeigneter Weise sandwichartig zwischen einer ersten und dritten Kunststoffplatte angeordnet ist, und wobei sich die erste, zweite und dritte Kunststoffplatte vorteilhaft parallel zu der ersten Leiterplatte erstrecken.

Die erste Leiterplatte ist dabei geeigneter Weise auf der dritten Kunststoffplatte angeordnet, wobei in der dritten Kunststoffplatte vorteilhaft eine Ausnehmung zur Beherbergung des Kontaktelements ausgebildet ist.

Auch die vorstehenden Merkmale gestatten eine besonders einfache und kompakte Bauform, wobei darüber hinaus ein derartiger erster Steckverbinder auf einfache Weise kostengünstig hergestellt werden kann.

Die in der dritten Kunststoffplatte ausgebildete Ausnehmung ist dabei geeigneter Weise derart ausgebildet und angeordnet, dass ein in ihr beherbergtes Kontaktelement in Kontakt zu dem Leiterbahnanschluss der ersten Leiterplatte steht und sich um einen vorbestimmten Betrag in den Steckbereich hinein erstreckt.

Besonders vorteilhaft weist die erste Leiterplatte eine vorbestimmte Flexibilität auf, wobei das Federelement ein Blattfederelement ist, das mittels einer in der ersten Leiterplatte ausgebildeten U-förmigen Ausnehmung bereitgestellt ist. Die U-förmige Ausnehmung umgreift dabei das Federelement, und der Leiterbahnanschluss ist auf dem Federelement angeordnet.

Die vorstehende vorteilhaft einstückige Ausbildung des Federelements mit der ersten Leiterplatte ermöglicht eine wünschenswerte Minimierung der Bauteile des ersten Steckverbinders und begünstigt dabei ebenfalls eine kompakte Bauform, die darüber hinaus besonders einfach hergestellt werden kann. Die U-förmige Ausnehmung kann bei der Herstellung der ersten Leiterplatte in die erste Leiterplatte gefräst werden.

Zur Bereitstellung einer wünschenswert flachen Bauform des ersten Steckverbinders kann eine vorbestimmt dünne dritte Kunststoffplatte vorgesehen sein. Dabei kann an dem einstückig mit der ersten Leiterplatte ausgebildeten Federelement ein Kontaktpad mit einer vorbestimmten Dicke derart an dem Leiterbahnanschluss der ersten Leiterplatte angeordnet sein, dass sich das Kontaktpad um einen vorbestimmten Betrag über die in der dritten Kunststoffplatte ausgebildete Ausnehmung hinaus derart in den Steckbereich erstreckt, dass das Kontaktpad in dem gesteckten Zustand des Steckverbinders einen Kontakt mit dem Leiterbahnanschluss der zu kontaktierenden Leiterplatte bereitstellt.

Auf diese Weise ist mittels dem vorstehenden Kontaktpad ein besonders einfaches Kontaktelement gebildet, wodurch außerdem eine weitere vorteilhafte Minimierung der Bauhöhe und Bauteile des Steckverbinders erzielt werden kann.

Auf der ersten Leiterplatte ist geeigneter Weise eine vierte Kunststoffplatte angeordnet, so dass eine Abdeckung der ersten Leiterplatte zum wünschenswerten Schutz der ersten Leiterplatte bereitgestellt ist. Die vierte Kunststoffplatte weist dabei geeigneter Weise eine Ausnehmung zur Beherbergung eines ausgelenkten einstückig mit der Leiterplatte ausgebildeten Federelements auf.

Wie eingangs erwähnt ist das Kontaktelement geeigneter Weise mittels einem Bauelement bereitgestellt, das in der in der dritten Kunststoffplatte ausgebildeten Ausnehmung beherbergt ist, wobei das Kontaktelement insbesondere vorteilhaft eine metallische Kugel ist.

Dabei ist in dem vorstehenden mit der ersten Leiterplatte einstückigen Federelement eine kreisförmige Ausnehmung mit einem leitfähigen Rand ausgebildet, mittels dem der Leiterbahnanschluss bereitgestellt ist. Das als Kugel ausgebildete Kontaktelement weist dabei eine mit der kreisförmigen Ausnehmung vorteilhaft zusammenwirkende Kontur auf, so dass eine wünschenswerte elektrische Kontaktierung des Kontaktelements mit dem kreisförmigen Leiterbahnanschluss bereitgestellt ist. Die Kugel wirkt dabei vorteilhaft formschlüssig mit dem kreisförmigen oder ringförmigen Leiterbahnanschluss zusammen.

Das als Kugel ausgebildete Kontaktelement ist insbesondere auch von Vorteil bei einem entsprechend dem vorstehenden kreisförmigen Leiterbahnanschluss der ersten Leiterplatte ebenfalls kreisförmig ausgebildetem Leiterbahnanschluss der zu kontaktierenden Leiterplatte, mittels dem eine Verrastung der gesteckten zu kontaktierenden Leiterplatte bereitgestellt sein kann.

Zum besseren Verständnis der Erfindung wird hier nachfolgend ein Steckvorgang der zu kontaktierenden Leiterplatte in den für sie in dem ersten Steckverbinder vorgesehenen Steckbereich am Beispiel des als Kugel ausgebildeten Kontaktelements und des einstückig mit der ersten Leiterplatte ausgebildeten Federelements beschrieben. Hierfür weisen die zu kontaktierende Leiterplatte und die den Steckbereich bildende Ausnehmung geeigneter Weise formschlüssig mit dem Kontaktelement korrespondierende Konturen auf, was auch für von dem genannten Beispiel verschiedene vorteilhafte Ausführungen gilt.

Das als Kugel ausgebildete Kontaktelement, die dritte Kunststoffplatte und das Federelement sind dabei geeigneter Weise derart ausgebildet und angeordnet, dass sich das Kontaktelement in ungestecktem Zustand des ersten Steckverbinders um einen vorbestimmten Betrag in den Steckbereich erstreckt.

Geeigneter Weise ist dabei die in der dritten Kunststoffplatte ausgebildete Ausnehmung, die das Kontaktelement beherbergt, in einem zu dem Steckbereich benachbarten Bereich verjüngt ausgebildet und weist an dem Steckbereich einen kreisförmigen Rand auf, der mit einer Metallschicht versehen sein kann. Der vorstehende kreisförmige Rand korrespondiert formschlüssig derart mit dem als Kugel ausgebildeten Kontaktelement, dass das Kontaktelement auf dem kreisförmigen Rand aufliegt und sich um den genannten vorbestimmten Betrag mit einem Abschnitt in den Steckbereich hinein erstreckt.

Geeigneter Weise ist dabei die dritte Kunststoffplatte und das Federelement derart ausgebildet und angeordnet, dass das Kontaktelement formschlüssig mit dem kreisförmigen Leiterbahnanschluss der ersten Leiterplatte derart korrespondiert, dass ein ringförmiger elektrischer und mechanischer Kontakt des Kontaktelements mit dem Leiterbahnanschluss bereitgestellt ist.

Die in der dritten Kunststoffplatte ausgebildete Ausnehmung ist dabei in ihrem weiteren Verlauf gegenüber dem vorstehenden, zu dem Steckbereich benachbarten Bereich derart erweitert und formschlüssig mit dem als Kugel ausgebildeten Kontaktelement beispielsweise zylindrisch ausgebildet. Das Kontaktelement wird beim Einstecken der zu kontaktierenden Leiterplatte mittels einer dabei an seinen sich in den Steckbereich erstreckenden ansetzenden und parallel zu der ersten Leiterplatte wirkenden Kraft von der zu kontaktierenden Leiterplatte in der zylindrischen Ausnehmung senkrecht zu der ersten Leiterplatte verschoben.

Bei der vorstehenden senkrechten Verschiebung des Kontaktelements wirkt nun eine senkrecht zur ersten Leiterplatte gerichtete Kraft auf das Federelement, wonach das Federelement in die in der vierten Kunststoffplatte ausgebildete Ausnehmung ausgelenkt wird, und wobei das Federelement eine entsprechende senkrecht zu dem Steckbereich gerichtete Gegenkraft auf das Kontaktelement ausübt.

Die kugelförmige Ausbildung des Kontaktelements ist dabei insbesondere auch besonders vorteilhaft, nachdem eine auftretende Reibung zwischen der zu kontaktierenden Leiterplatte und dem Kontaktelement ein Rollen der Kugel auslöst. Bei fortschreitendem Einstecken der zu kontaktierenden Leiterplatte in den Steckbereich kann die zum Einstecken der zu kontaktierenden Leiterplatte benötigte Kraft daher wünschenswert gering und darüber hinaus etwa konstant gehalten werden kann. Auf diese Weise kann insbesondere auch ein Widerstand des Kontaktelements beim ersten mechanischen Kontakt der zu kontaktierenden Leiterplatte mit dem Kontaktelement vorteilhaft gering gehalten werden.

Wie vorstehend erwähnt kann an der ersten Leiterplatte ein kreisförmiger Leiterbahnanschluss ausgebildet sein, der formschlüssig mit dem Kontaktelement zusammenwirkt, wobei der Leiterbahnanschluss der zu kontaktierenden Leiterplatte ebenfalls mittels einem geeigneten kreisförmigen Rand einer Ausnehmung in der zu kontaktierenden Leiterplatte ausgebildet sein kann.

Im weiteren Verlauf des Einsteckens der zu kontaktierenden Leiterplatte gleitet und/oder rollt das dabei in Richtung auf die erste Leiterplatte verschoben werdende Kontaktelement auf einer Seite der zu kontaktierenden Leiterplatte, wobei eine Federkraft des Federelements das Kontaktelement senkrecht zu der zu kontaktierenden Leiterplatte auf die zu kontaktierende Leiterplatte drückt.

Die erwähnte kreisförmige Ausnehmung in der zu kontaktierenden Leiterplatte ist dabei in vollständig gestecktem Zustand derart korrespondierend mit der in der dritten Kunststoffplatte ausgebildeten Ausnehmung und dem Kontaktelement ausgebildet und angeordnet, dass das Kontaktelement von dem Federelement in die kreisförmige Ausnehmung der zu kontaktierenden Leiterplatte gedrückt wird, wenn ein gesteckter Zustand des ersten Steckverbinders mit einer Verrastung bereitgestellt ist.

Bei der vorstehend beschriebenen Anordnung des ersten Steckverbinders in gestecktem Zustand ist insbesondere mittels der beschriebenen Anordnung und Ausbildung der ersten Leiterplatte und der zu kontaktierenden Leiterplatte mit ihren kreisförmigen Ausnehmungen und dem kugelförmigen Kontaktelement vorteilhaft eine elektrische Verbindung der Leiterbahnanschlüsse der beiden parallel zueinander angeordneten Leiterplatten bereitgestellt. Außerdem ist dabei eine Verrastung des ersten Steckverbinders mit der zu kontaktierenden Leiterplatte bereitgestellt, wonach das Kontaktelement eine besonders vorteilhafte Doppelfunktion aufweist.

Der vorstehend beschriebene Steckvorgang der zu kontaktierenden Leiterplatte in den für sie in dem ersten Steckverbinder vorgesehenen Steckbereich wurde anhand eines vorteilhaften Ausführungsbeispiels der Erfindung des als Kugel ausgebildeten Kontaktelements und des einstückig mit der Leiterplatte ausgebildeten Federelements beschrieben.

Die vorstehend beschriebenen Vorteile dieses Ausführungsbeispiels lassen sich auch mit abgewandelten Ausführungen erzielen, wobei hier ebenfalls beispielhaft eine zylindrische Ausbildung des Kontaktelements mit entsprechend weiteren abgewandelten Ausführungen der in der dritten Kunststoffplatte ausgebildeten Ausnehmung und der Leiterbahnanschlüsse genannt wird.

Eine kostengünstige erste Leiterplatte und zu kontaktierende Leiterplatte, die mit gängigen Verfahren auf einfache Weise auch mit Bauelementen bestückbar sein können, kann vorteilhaft mittels einer ein- oder mehrlagigen Standardleiterplatte bereitgestellt werden.

Weiterhin kann die erste und/oder zweite und/oder dritte und/oder vierte Kunststoffplatte geeigneter Weise jeweils mittels wenigstens einer kupferlosen Leiterplatte bereitgestellt sein.

Die zweite Kunststoffplatte kann dabei von einer zweiten Leiterplatte gebildet sein, wobei der Steckbereich als Ausnehmung in der zweiten Leiterplatte ausgebildet ist.

Die dritte Kunststoffplatte kann geeigneter Weise von einer dritten und vierten Leiterplatte gebildet sein, wobei in der dritten und vierten Leiterplatte jeweils eine Ausnehmung ausgebildet ist. Die in der dritten Leiterplatte ausgebildete Ausnehmung und in der vierten Leiterplatte ausgebildete Ausnehmung können dabei auf einfache Weise derart unterschiedlich ausgebildet sein, dass eine Ausnehmung zur Beherbergung des Kontaktelements bereitgestellt ist, in der das Kontaktelement derart verschiebbar beherbergt ist, dass das Kontaktelement von einer in der in der dritten Leiterplatte ausgebildeten Kontur gehalten ist und darüber hinaus um einen vorbestimmten Betrag in den Steckbereich des ersten Steckverbinders hineinragt.

Geeigneter Weise kann insbesondere bei einer jeweils in der vorstehenden dritten und vierten Leiterplatte zylindrisch ausgebildeten Ausnehmung, die Ausnehmung in einem zu dem Steckbereich benachbarten Bereich insbesondere derart verjüngt ausgebildet sein, indem die zylindrische Ausnehmung der dritten Leiterplatte mit einem vergleichsweise verjüngten Durchmesser bereitgestellt ist und dabei außerdem eine vorbestimmte Dicke aufweist.

Auf diese Weise kann die vorstehende zur Beherbergung eines kugelförmigen Kontaktelements besonders geeignete Ausnehmung in der dritten Kunststoffplatte besonders einfach von der in der dritten und vierten Leiterplatte ausgebildeten Ausnehmung bereitgestellt sein. Die erste Leiterplatte kann dabei geeigneter Weise auf der vorstehenden vierten Leiterplatte angeordnet sein, wobei die dritte Leiterplatte auf der zweiten Leiterplatte angeordnet ist. Die vorstehenden Ausnehmungen können auf einfache Weise mittels Fräsen oder Bohren ausgebildet werden.

Dabei ist aus der vorstehenden Beschreibung klar, dass die in der dritten Leiterplatte ausgebildete Ausnehmung benachbart und in Kontakt zu dem Steckbereich angeordnet ist und steht, wobei das Kontaktelement in der in der vierten Leiterplatte ausgebildeten Ausnehmung angeordnet ist und wie vorstehend anhand einer vorteilhaften Ausführung des Kontaktelements beschrieben über die in der dritten Leiterplatte ausgebildete Ausnehmung um einen vorbestimmten Betrag in den Steckbereich hineinragt.

Die vierte Kunststoffplatte kann von einer übereinander angeordneten fünften und sechsten Leiterplatte gebildet sein, wobei die fünfte Leiterplatte auf der vierten Leiterplatte angeordnet ist, und wobei in der fünften Leiterplatte geeigneter Weise eine Ausnehmung zur Beherbergung des vorstehend beschriebenen, mit der ersten Leiterplatte einstückigen Federelements ausgebildet ist.

Die vorstehend beschriebene dritte, vierte, erste, fünfte und sechste Leiterplatte können in dieser Reihenfolge übereinander angeordnet geeigneter Weise einen Leiterplatten-Stack bilden.

Weiterhin kann die vorstehend beschriebene erste Kunststoffplatte, die benachbart zu dem Steckbereich angeordnet ist, und benachbart zu der die zweiten Kunststoffplatte angeordnet ist, von einer siebten Leiterplatte gebildet sein, wobei die zweite Leiterplatte auf der siebten Leiterplatte angeordnet ist.

Bei der vorstehenden Ausführung der Erfindung ist auf einer Seite der zweiten Leiterplatte ein erster vorstehend beschriebener Leiterplatten-Stack angeordnet, wobei die dritte Leiterplatte des Leiterplatten-Stacks auf einer Seite der zweiten Leiterplatte angeordnet ist und die siebte Leiterplatte auf der anderen Seite der zweiten Leiterplatte angeordnet ist.

An Stelle der siebten Leiterplatte kann auf einer Seite der zweiten Leiterplatte ein zweiter vorstehend beschriebener Leiterplatten-Stack angeordnet sein, der wie der erste Leiterplatten-Stack ebenfalls eine genannte dritte, vierte, erste, fünfte und sechste Leiterplatte aufweist, die in dieser Reihenfolge übereinander gestapelt sind, wobei die dritte Leiterplatte des zweiten Leiterplatten-Stacks auf einer Seite der zweiten Leiterplatte angeordnet ist.

Auf diese Weise kann auf einfache Weise ein vorteilhafter erster Steckverbinder nach einer Ausführung der Erfindung bereitgestellt sein, der zwei erste Leiterplatten mit einem Leiterbahnanschluss zur Bereitstellung einer elektrischen Verbindung mit einem Leiterbahnanschluss der zu kontaktierenden Leiterplatte aufweist.

Der erste und zweite Leiterplatten-Stack können unterschiedlich insbesondere auch in der Anordnung und Ausbildung der Leiterbahnen und/oder der Leiterbahnanschlüsse der ersten Leiterplatten und/oder des Kontaktelements und/oder des Federelements ausgebildet sein. Der erste und zweite Leiterplatten-Stack können auch identisch ausgebildet sein, wonach der zwei erste Leiterplatten aufweisende erste Steckverbinder spiegelsymmetrisch zu seiner mittig angeordneten zweiten Leiterplatte ausgebildet sein kann.

Die beschriebenen Leiterplatten können auch jeweils mittels mehreren Leiterplatten bereitgestellt sein, wobei ein einfaches Design der Dicke der funktionalen Leiterplatten des ersten Steckverbinders möglich ist.

Die zu kontaktierende Leiterplatte kann vorteilhaft Bestandteil eines zweiten Steckverbinders sein, wonach die Erfindung außerdem insbesondere einen zweiten Steckverbinder zur Bereitstellung einer elektrischen Verbindung eines Leiterbahnanschlusses der zu kontaktierenden Leiterplatte mit einem Leiterbahnanschluss einer weiteren Leiterplatte betrifft. Die weitere Leiterplatte kann dabei geeigneter Weise eine erste Leiterplatte des vorstehend beschriebenen ersten Steckverbinders sein.

Geeigneter Weise weist der zweite Steckverbinder ein Gehäuse mit wenigstens zwei Kunststoffplatten auf, das mittels einem Leiterplatten-Stack bereitgestellt sein kann. Die wenigstens zwei Kunststoffplatten können jeweils mittels wenigstens einer Leiterplatte bereitgestellt sein, die auch kupferlos sein kann.

Die zu kontaktierende Leiterplatte ist dabei sandwichartig zwischen den wenigstens zwei Kunststoffplatten und/oder Leiterplatten angeordnet und ragt zum Einstecken in den Steckbereich des ersten Steckverbinders mit ihrem Steckbereich aus dem Gehäuse des zweiten Steckverbinders heraus.

Der Leiterbahnanschluss der zu kontaktierenden Leiterplatte des zweiten Steckverbinders kann wie vorstehend gesagt insbesondere mittels einem Rand einer in der zu kontaktierenden Leiterplatte ausgebildeten Ausnehmung bereitgestellt sein, wobei mittels dem Leiterbahnanschluss außerdem ein Rastelement zur Verrastung mit dem ersten Steckverbinder bereitgestellt sein kann.

Die zu kontaktierende Leiterplatte des zweiten Steckverbinders kann eine Vielzahl von Leiterbahnen und/oder Leiterbahnanschlüssen aufweisen, wobei die Leiterbahnen und/oder die Leiterbahnanschlüsse auf beiden Seiten der zu kontaktierenden Leiterplatte ausgebildet sein können. Das vorstehend gesagte gilt geeigneter Weise auch entsprechend für die erste Leiterplatte des vorstehend beschriebenen ersten Steckverbinders.

Der erste und zweite Steckverbinder kann dabei für ein vorbestimmtes Design und/oder eine vorbestimmte Funktionalität auf einfache Weise für viele Anwendungen optimiert mittels beispielsweise Vorsehung einer vorbestimmten Anzahl von auch in Steckrichtung nebeneinander und/oder hintereinander und/oder aufeinanderfolgend auch redundanten Leiterbahnanschlüssen abgewandelt werden.

Die zu kontaktierende Leiterplatte des zweiten Steckverbinders kann an ihrem Steckbereich eine Kontur aufweisen mittels dem eine Kodierung des zweiten Steckverbinders bereitgestellt sein kann, wobei die Kontur mit einer Innenkontur eines Steckbereichs des ersten Steckverbinders korrespondierend ausgebildet sein kann. Auch diese Maßnahme ermöglicht ein ausgewähltes auf eine vorbestimmte Anwendung optimiertes Design des ersten und zweiten Steckverbinders.

Die zu kontaktierende Leiterplatte des zweiten Steckverbinders kann einseitig oder beidseitig mit wenigstens einem Leiterbahnanschluss versehen sein. Alternativ können auch zwei zu kontaktierende Leiterplatten übereinander angeordnet zusammengesetzt sein, wobei deren mit einem Leiterbahnanschluss versehene Seiten entgegengerichtet angeordnet sind.

Mittels dem zweiten Steckverbinder kann wie vorstehend beschrieben ein Gegensteckverbinder des ersten Steckverbinders bereitgestellt sein.

Eine geeignete keine Leiterbahn aufweisende Leiterplatte des ersten und zweiten Steckverbinders kann insbesondere auch kostengünstig mittels einer kupferlosen Standardleiterplatte bereitgestellt sein, die mit einer Dicke von 0.5 mm bis 3.2 mm industriell standardmäßig zur Verfügung stehen. Die beschriebenen Ausnehmungen in den Leiterplatten können geeigneter Weise mittels Fräsen als durch die Leiterplatten durchgehende Löcher ausgebildet werden.

Die Kunststoffplatten bzw. die kupferlosen Leiterplatten können wie vorstehend gesagt mittels vorteilhaft einfachen Leiterplatten, auf denen kein Kupfer benötigt wird, kostengünstig bereitgestellt werden. Geeignet hierfür sind insbesondere FR4 Leiterplatten, die ein besonders stabiles und feuerfestes Gehäuse ermöglichen.

Die Leiterplatten eines vorstehend beschriebenen ersten und zweiten Steckverbinders können auf einfache Weise miteinander verklebt sein, wodurch ein Gehäuse des ersten und zweiten Steckverbinders bereitgestellt ist. Als geeigneter Klebstoff kann beispielsweise und vorteilhaft Sekundenkleber verwendet werden.

Eine erste Leiterplatte des ersten Steckverbinders und eine zu kontaktierende Leiterplatte des zweiten Steckverbinders kann ein- oder beidseitig mit elektrischen und/oder elektronischen Bauelementen bestückt sein, wobei entsprechende Ausnehmungen zur Beherbergung der Bauelemente in die entsprechend zu der ersten und der zu kontaktierenden Leiterplatte benachbart angeordneten Leiterplatten geeigneter Weise mittels Fräsen ausgebildet sein können. Als beispielhafte und vorteilhafte geeignete elektrische und/oder elektronische Bauelementen seien hier Bauelemente einer elektronischen Sensorik erwähnt.

Auch durch die vorstehende Maßnahme ist vorteilhaft die Möglichkeit geschaffen, einen für eine vorbestimmte Anwendung optimiert ausgebildeten Steckverbinder bereitzustellen, der eine vorbestimmte Funktionalität aufweist.

Die Ausnehmungen zur Beherbergung der Bauelemente können mit Kunststoff vergossen sein, so dass die in den Ausnehmungen angeordneten Bauelemente gegenüber Vibrationen geschützt sind. Ein zum Vergießen der Ausnehmungen geeignetes Kunstharz kann beispielsweise Epoxyd-Harz sein.

Es ist klar, dass die mit Leiterbahnen versehenen Leiterplatten des ersten und zweiten Steckverbinders auch mit Kabeln verlötet sein können, oder mehr als einen Steckbereich aufweisen können. Beispielsweise sei hier ein Steckverbinder genannt, der auf seiner einen Seite als erster und auf seiner gegenüberliegenden Seite als zweiter Steckverbinder ausgebildet ist.

Der vorstehend beschriebene insbesondere erste Steckverbinder ist besonders geeignet eine elektrische Kontaktierung an einem Rand einer Leiterplatte zu ermöglichen, wonach die Erfindung außerdem insbesondere eine Leiterplatte betrifft, an deren Rand wenigstens ein vorstehend beschriebener zweiter Steckverbinder vorgesehen ist. Für eine wünschenswerte weitere Möglichkeit der Kontaktierung der Leiterplatte kann an dem Rand der Leiterplatte weiterhin wenigstens ein erster Steckverbinder ausgebildet sein. Dabei ist die Leiterplatte vorteilhaft jeweils einstückig mit einer ersten Leiterplatte des ersten Steckverbinders und/oder mit einer zu kontaktierenden Leiterplatte des zweiten Steckverbinders ausgebildet.

Ein vorstehend beschriebener erster und zweiter Steckverbinder kann wie vorstehend erwähnt vorteilhaft auf vielfältige Weise für viele Anwendungen optimiert designed werden. Beispiele werden auch nachfolgend anhand von Ausführungsbeispielen unter Bezugnahme auf die Zeichnungen angesprochen.

### Ausführungsbeispiele

Ausführungsbeispiele der Erfindung sind in den Zeichnungen dargestellt und werden im Folgenden näher erläutert. Es zeigen:
- Fig. 1A: einen Schnitt durch einen Ausschnitt eines Steckverbinders nach einer Ausführung der Erfindung;
- Fig. 1B: den Steckverbinder von Fig. 1A in gestecktem Zustand;
- Fig. 2: einen Schnitt durch einen Ausschnitt eines Steckverbinder nach einer Ausführung der Erfindung in gestecktem Zustand;
- Fig. 3A: eine perspektivische Darstellung eines Ausschnitts eines ersten und zweiten Steckverbinders nach einer Ausführung der Erfindung;
- Fig. 3B: den ersten und zweiten Steckverbinder von Fig. 3A in gestecktem Zustand;
- Fig. 4A: eine Draufsicht auf die Einstecköffnung des Steckbereichs des ersten Steckverbinders von Fig. 3A;
- Fig. 4B: eine Draufsicht auf Leiterplatten, die für den zweiten Steckverbinder von Fig. 3A geeignet sind;
- Fig. 4C: eine Draufsicht auf Leiterplatten des ersten Steckverbinders von Fig. 3A;
- Fig. 5A: eine perspektivische Darstellung eines ersten und zweiten Steckverbinders nach einer Ausführung der Erfindung;
- Fig. 5B: eine Seitenansicht des ersten und zweiten Steckverbinders von Fig. 5A;
- Fig. 6A: schematische Darstellungen von Ausführungen eines Steckverbinders nach einer Ausführung der Erfindung; und
- Fig. 6B: schematische Darstellungen von Ausführungen eines ersten und zweiten Steckverbinders nach einer Ausführung der Erfindung.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

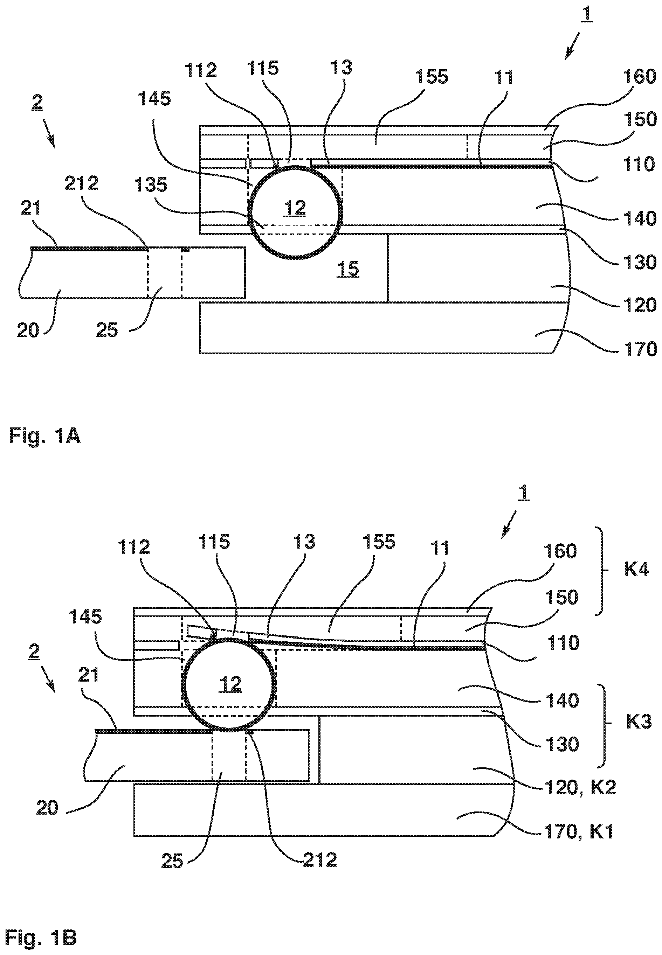

Fig. 1A zeigt einen Schnitt durch einen Ausschnitt eines ersten Steckverbinders 1 nach einer Ausführung der Erfindung zusammen mit einem Steckbereich einer mittels dem Steckverbinder 1 zu kontaktierenden Leiterplatte 20. Fig. 1B zeigt den Steckverbinder 1 und die zu kontaktierende Leiterplatte 20 von Fig. 1A in gestecktem Zustand.

Der Steckverbinder 1 weist eine eingangs beschriebene siebte 170, zweite 120, dritte 130, vierte 140, erste 110, fünfte 150 und sechste 160 Leiterplatte auf, die in dieser Reihenfolge übereinander angeordnet sind. Die vorstehenden Leiterplatten können miteinander verklebt sein und stellen ein Gehäuse des Steckverbinders 1 bereit.

Die erste Leiterplatte 110 weist eine Leiterbahn 11 auf, die an ihrem Ende mit einem Leiterbahnanschluss 112 versehen ist. Der Leiterbahnanschluss 112 ist mittels einem kreisförmigen Rand bereitgestellt, der an einer kreisförmigen Ausnehmung 115 der Leiterplatte 110 ausgebildet ist. Die erste Leiterplatte 110 weist außerdem eine vorbestimmte Flexibilität auf und ist mit ihrer Leiterbahn 11 benachbart zu der vierten Leiterplatte 140 auf der vierten Leiterplatte 140 angeordnet.

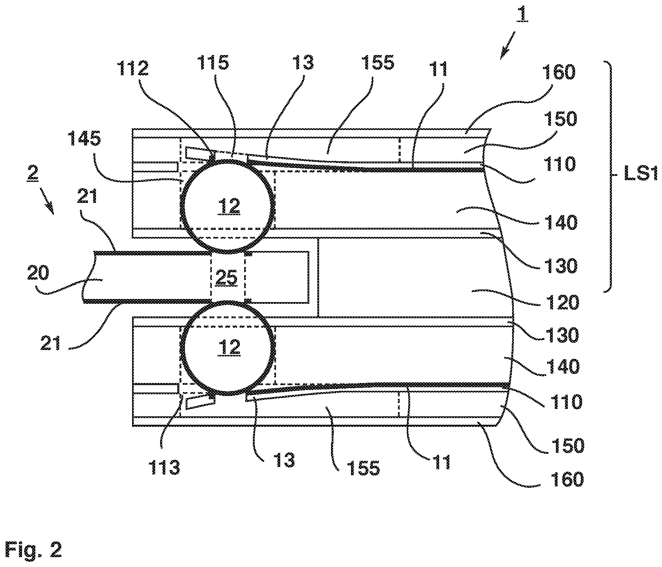

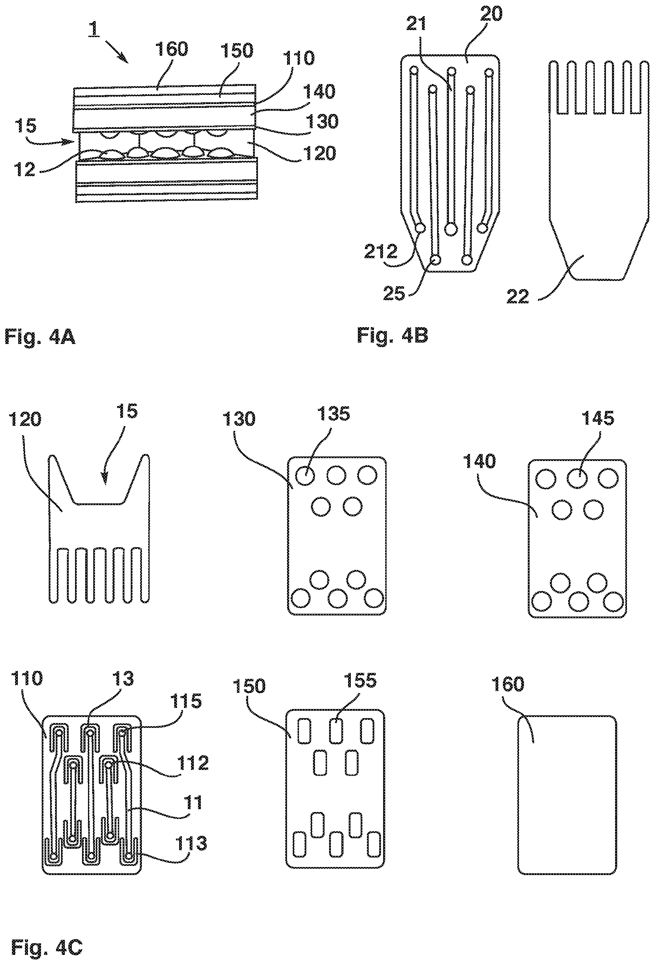

In der ersten Leiterplatte 110 ist außerdem eine U-förmige Ausnehmung 113 ausgebildet, die den Leiterbahnanschluss 112 umgreift. Zu der U-förmigen Ausnehmung wird hier auch auf Fig. 2 und Fig. 4C verwiesen. Mittels der U-förmigen Ausnehmung liegt ein blattförmiger Abschnitt der Leiterplatte 110 mit drei Seiten frei. Auf diese Weise ist ein als Blattfeder ausgebildetes und mit der flexiblen ersten Leiterplatte 110 einstückiges Federelement 13 bereitgestellt.

Für eine wünschenswerte vorbestimmte Auslenkung des Federelements 13 ist in der auf der ersten Leiterplatte 110 angeordneten fünften Leiterplatte 150 eine geeignete Ausnehmung ausgebildet, wobei die fünfte Leiterplatte hierfür auch eine vorbestimmte Dicke aufweist. Mittels der sechsten Leiterplatte 160, die auf der fünften Leiterplatte 150 angeordnet ist, ist eine Abdeckung der fünften Leiterplatte 150 mit der Ausnehmung 155 bereitgestellt, die auch die erste Leiterplatte 110 nach außen abdeckt.

Die erste Leiterplatte 110 ist auf der vierten Leiterplatte 140 angeordnet, wobei für eine wünschenswerte vorbestimmte Auslenkung des Federelements 13 die erste Leiterplatte 110 in einem vorbestimmten geeigneten Abschnitt der ersten Leiterplatte 110 nicht mit der vierten Leiterplatte 140 verklebt ist. In der vierten Leiterplatte 140 ist eine Ausnehmung 145 ausgebildet, in der das kugelförmige Kontaktelement 12 beherbergt ist. Die Ausnehmung 145 ist dabei geeigneter Weise formschlüssig mit dem Kugelelement 12 zylindrisch ausgebildet.

Der kreisförmige Leiterbahnanschluss 12 liegt auf dem oberen Rand des Kontaktelements 12 an, so dass der Leiterbahnanschluss 112 in Kontakt mit dem Kontaktelement 12 gebracht ist. Die vierte Leiterplatte 140 ist auf der dritten Leiterplatte 130 angeordnet, die ebenfalls eine zylindrische Ausnehmung 135 aufweist, wobei die Ausnehmung 135 gegenüber der Ausnehmung 145 in der vierten Leiterplatte 140 verjüngt ausgebildet ist.

Durch diese Maßnahme ist das formschlüssig mit der zylindrischen Ausnehmung 135, die einen kreisförmigen Rand aufweist, als Kugel ausgebildete Kontaktelement 12 in der Ausnehmung 145 beherbergt und sitzt dabei auf dem Rand der Ausnehmung 135.

Die dritte Leiterplatte 130 weist dabei eine vergleichsweise zu der vierten Leiterplatte 140 geringe Dicke auf. Die dritte Leiterplatte 130 ist auf der zweiten Leiterplatte 120 angeordnet, in der eine Ausnehmung 15 ausgebildet ist, mittels der der Steckbereich 15 des Steckverbinders 1 bereitgestellt ist. Die zweite Leiterplatte 120 ist dabei sandwichartig zwischen der dritten Leiterplatte 130 und der siebten Leiterplatte 170 angeordnet, wobei die zweite Leiterplatte 120 auf einer Seite der siebten Leiterplatte 170 angeordnet ist.

Fig. 1A zeigt dabei den Steckverbinder 1 in ungestecktem Zustand, wobei die mittels dem Steckverbinder 1 zu kontaktierende Leiterplatte 20 an der Einstecköffnung des Steckbereichs 15 angeordnet ist. In diesem Zustand des Steckverbinders erstreckt sich das Kontaktelement 12 mit einem Abschnitt um einen vorbestimmten Betrag teilweise in den Steckbereich 15. Der Steckbereich 15 des Steckverbinders 1 ist dabei parallel zu der ersten Leiterplatte 110 angeordnet.

Die an der Einstecköffnung des Steckbereichs 15 befindliche Leiterplatte 20 weist eine Leiterbahn 21 mit einem Leiterbahnanschluss 212, der wie der Leiterbahnanschluss 112 der ersten Leiterplatte 110 mittels einem Rand einer kreisförmigen Ausnehmung 25 in der Leiterplatte 20 bereitgestellt ist. Der Leiterbahnanschluss 212 ist dabei derart auf der Leiterplatte 20 ausgebildet und angeordnet, dass der Leiterbahnanschluss 212 in dem gesteckten Zustand der Leiterplatte 20 gegenüber dem Leiterbahnanschluss 112 der ersten Leiterplatte 110 angeordnet ist.

In dem gesteckten Zustand des Steckverbinders 1, der in Fig. 1B dargestellt ist, ist mittels dem Kontaktelement 12 eine elektrische Verbindung des Leiterbahnanschlusses 212 mit dem Leiterbahnanschluss 112 bereitgestellt, wobei das Kontaktelement 12 senkrecht zu der Leiterplatte 110 verschoben ist und das Federelement 13 ausgelenkt ist.

Das Federelement 13 drückt dabei das Kontaktelement 12 in die mit dem Kontaktelement 12 formschlüssig ausgebildete Ausnehmung 25, so dass ein zuverlässiger elektrischer Kontakt und darüber hinaus eine Verrastung der zu kontaktierenden Leiterplatte 20 bereitgestellt ist. Zu dem Steckvorgang beim Einstecken der Leiterplatte 20 in den Steckbereich wird auf die vorstehende Beschreibung verwiesen. Mittels dem Steckverbinder 1 von Fig. 1A und B ist beispielhaft ein besonders einfacher Steckverbinder 1 bereitgestellt, dessen erste Leiterplatte 110 beispielhaft insbesondere auch zum besseren Verständnis der Erfindung lediglich eine Leiterbahn 11 mit einem Leiterbahnanschluss 112 aufweist.

Die Leiterplatten 120, 130, 140, 150, 160 und 170 können geeigneter Weise mittels wenigstens einer kupferlosen Standardleiterplatte bereitgestellt sein. Die zweite Leiterplatte 120 kann auch eine Kunststoffplatte K2 sein, die sandwichartig wie in der Zeichnung dargestellt zwischen einer ersten K1 und dritten K3 Kunststoffplatte angeordnet ist, wobei in der dritten Kunststoffplatte K3 eine den Ausnehmungen 135 und 145 entsprechende Ausnehmung 135, 145 ausgebildet ist. Die fünfte 150 und sechste 160 Leiterplatte kann mittels einer auf der dritten Kunststoffplatte angeordneten vierten Kunststoffplatte K4 bereitgestellt sein, wobei die Kunststoffplatte K4 mit der Ausnehmung 155 versehen ist.

In seinem in den Zeichnungen nicht dargestellten Bereich kann der Steckverbinder beispielhaft ein Kabel aufweisen, das mit einem weiteren Leiterbahnanschluss des Steckverbinders 1 verlötet sein kann, und das aus dem Gehäuse des Steckverbinders 1 nach außen führen kann.

Die zu kontaktierende Leiterplatte 20 kann Bestandteil eines Steckverbinders 2 sein, der als Gegensteckverbinder zu dem Steckverbinder 1 ausgebildet ist.

Fig. 2 zeigt einen Schnitt durch einen Ausschnitt eines Steckverbinders 1 nach einer Ausführung der Erfindung in gestecktem Zustand. Der Steckverbinder 1 von Fig. 2 weist wie der Steckverbinder 1 von Fig. 1A und B eine zweite Leiterplatten 120 auf, in der ein Steckbereich 15 mittels einer Ausnehmung mit einer Einstecköffnung gebildet ist.

Auf der Leiterplatte 120 ist ein erster Leiterplatten-Stack LS1 angeordnet, der die vorstehend beschriebenen Leiterplatten 130, 140, 110, 150 und 160 aufweist, die in dieser Reihenfolge übereinander gestapelt auf einer Seite der Leiterplatte 120 angeordnet sind. Der Steckverbinder 2 von Fig. 2 entspricht soweit dem Steckverbinder 2 von Fig. 1A und B, weshalb diesbezüglich auf die entsprechende vorstehende Beschreibung verwiesen wird.

Anders als bei dem Steckverbinder 2 von Fig. 1A und 1B ist bei dem Steckverbinder 2 von Fig. 2 an Stelle der siebten Leiterplatte 170 auf deren Seite der zweiten Leiterplatte 120 ein zweiter Leiterplatten-Stack LS1 spiegelbildlich zu dem ersten Leiterplatten-Stack LS1 angeordnet, wobei der erste und zweite Leiterplatten-Stack LS1 identisch ausgebildet sind.

Die in die Einführausnehmung 15 des Steckverbinders 2 gesteckte zu kontaktierende Leiterplatte 20 weist anders als die Leiterplatte 20 der Ausführung von Fig. 1A und 1B beidseitig ausgebildete Leiterbahnen 11 und Leiterbahnanschlüsse 212 zur Bereitstellung einer elektrischen Verbindung mit den beiden gegenüberliegenden und spiegelsymmetrisch angeordneten Leiterbahnanschlüssen 112 der ersten Leiterplatten 110 auf. Ansonsten entspricht die Leiterplatte 20 der Ausführung von Fig. 2 der Leiterplatte 20 von Fig. 1A und B, weshalb diesbezüglich auf die entsprechende Beschreibung verwiesen wird.

Die Leiterplatte 20 der Ausführung von Fig. 2 kann ebenfalls Bestandteil eines Steckverbinders 2 nach einer Ausführung der Erfindung sein, der als Gegensteckverbinder zu dem Steckverbinder 1 ausgebildet sein kann. Der Steckverbinder 1 von Fig. 2 kann in seinem in der Zeichnung nicht dargestellten Bereich beispielsweise als ein vorstehender, eine zu kontaktierende Leiterplatte 2 von Fig. 2 aufweisender Steckverbinder 2 sein.

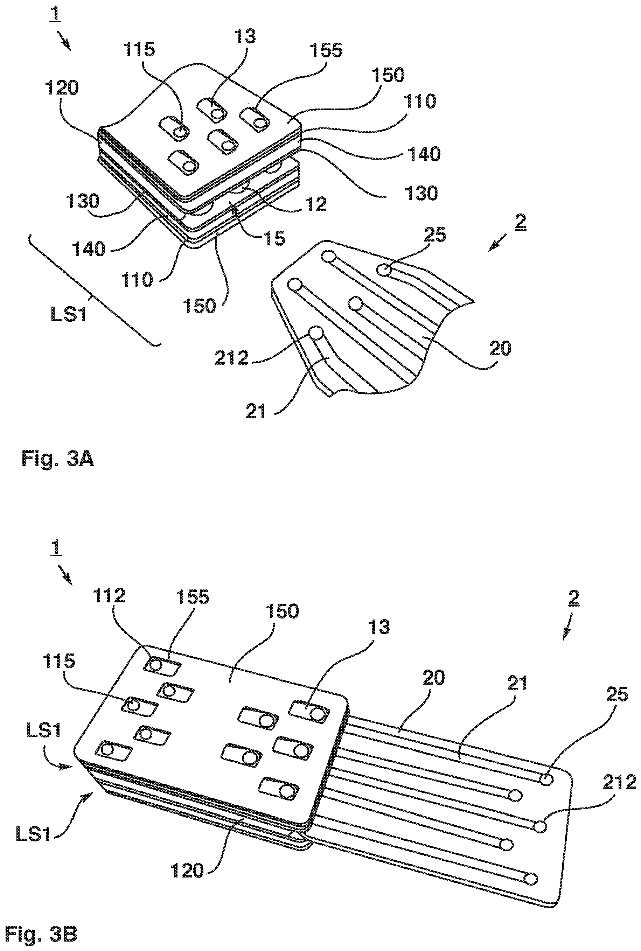

Fig. 3A zeigt eine perspektivische Darstellung eines Ausschnitts eines ersten 1 und zweiten 2 Steckverbinders nach einer Ausführung der Erfindung und Fig. 3B zeigt den ersten 1 und zweiten 2 Steckverbinder von Fig. 3A ineinander gesteckt.

Der Leiterplatten-Stack des Steckverbinders 1 von Fig. 3A und 3B entspricht im Wesentlichen dem Leiterplatten-Stack LS1 von Fig. 2, weshalb diesbezüglich auf die entsprechende Beschreibung verwiesen wird. Zum besseren Verständnis ist in Fig. 3A und 3B die sechste Leiterplatte 160 nicht dargestellt. Anders als der Steckverbinder 1 von Fig. 2 weisen die ersten Leiterplatten 10 des Steckverbinders 1 vom Fig. 3A und B an dem Steckbereich 15 des Steckverbinders 1 jeweils fünf Federelemente 13 mit fünf Leiterbahnanschlüssen 112 mit jeweils einem entsprechend zugeordneten Kontaktelement 12 auf.

Zum besseren Verständnis wird in diesem Zusammenhang zusätzlich auf Fig. 4A und 4C verwiesen, die jeweils eine Draufsicht auf die Einstecköffnung des Steckbereichs 15 des Steckverbinders 1 und auf die Leiterplatten des Leiterplatten-Stacks LS1 und insbesondere auch auf eine erste Leiterplatte 110 zeigen.

An der dem Steckbereich 15 des Steckverbinders 1 gegenüberliegenden Seite des Steckverbinders 1 sind beispielhaft ebenfalls fünf Federelemente 13 mit den ihnen zugeordneten Leiterbahnanschlüssen 112 ausgebildet, die jeweils in Steckrichtung einer entsprechenden an der anderen Seite ausgebildeten Öffnungen des Steckverbinders 1 in zwei Reihen angeordnet sind, die näher zueinander beabstandet angeordnet sind als die an dem Steckbereich 15 senkrecht zur Steckrichtung angeordneten Reihen der Leiterbahnanschlüsse 112. Die fünf Leiterbahnanschlüsse 112 sind dabei auf einfache Weise jeweils direkt mit einem gegenüberliegenden Leiterbahnanschluss 112 mittels einer Leiterbahn 11 verbunden. Diesbezüglich und zu der nachfolgenden Beschreibung auch des Steckbereichs 15 des Steckverbinders 1 wird erneut auch auf Fig. 4C verwiesen.

Der mittels einer Ausnehmung in der zweiten Leiterplatte 120 ausgebildete Steckbereich 15 weist eine trapezartig zulaufende Innenkontur, auf mittels dem eine vorteilhafte mechanische Kodierung des Steckverbinders 1 bereitgestellt ist, wobei mittels der Kodierung sichergestellt ist, dass lediglich eine mit der Innenkontur des Steckbereichs 15 korrespondierende Kontur eines Steckbereichs einer zu kontaktierenden Leiterplatte 20 eines Steckverbinders 2 in den Steckverbinder 1 gesteckt werden kann.

Die Leiterplatte 20 der Ausführung von Fig. 3A und B weist eine entsprechende mit der Innenkontur des Steckbereichs korrespondierende Kontur auf, und damit ebenfalls eine vorteilhafte mechanische Kodierung auf, die mit der Kodierung des Steckverbinders 1 übereinstimmt, wonach eine derartige Leiterplatte 20 eines Steckverbinders 2 in den Steckverbinder 1 gesteckt werden kann.

Ein Gehäuse des Steckverbinders 2 von Fig. 3A und B ist in den Zeichnungen der Einfachheit und Übersichtlichkeit halber nicht dargestellt, wobei ein geeignetes Gehäuse beispielsweise eine erste und zweite Kunststoffplatte sein kann, wobei die Leiterplatte 20 sandwichartig zwischen der ersten und zweiten Kunststoffplatte angeordnet und beherbergt sein kann.

An der dem Steckbereich des zweiten Steckverbinders 2 gegenüberliegenden Seite der Leiterplatte 20 sind ebenfalls fünf Leiterbahnanschlüsse 212 ausgebildet, die den fünf an dem Steckbereich angeordneten Leiterbahnanschlüssen 212 korrespondieren, wobei die Leiterbahnanschlüsse 212 wie in Fig. 4B am besten dargestellt beispielhaft auf einfache Weise jeweils mittels einer Leiterbahn 21 mit einem gegenüberliegenden Leiterbahnanschluss 212 verbunden sind.

An der in der Zeichnung nicht dargestellten gegenüberliegenden Seite der Leiterplatte 20 können jeweils spiegelbildlich zu den Leiterbahnen 21 und den Leiterbahnanschlüssen 212 angeordnete Leiterbahnen 21 und Leiterbahnanschlüsse 212 zur Bereitstellung jeweils einer elektrischen Verbindung mit den korrespondierenden an den beiden ersten Leiterplatten 110 des ersten Steckverbinders 1 vorgesehenen Leiterbahnanschlüssen 112 angeordnet sein.

Bei einer besonders dicken zweiten Leiterplatte 120 des ersten Steckverbinders 1 kann auch eine entsprechende kupferlose Leiterplatte 22 als Abstandsplatte sandwichartig zwischen zwei zweiten Leiterplatten 20 angeordnet sein. Beispielsweise kann die Leiterplatte 22 an der ihrem Steckbereich gegenüberliegenden Seite eine kammartige Struktur mit entsprechenden Ausnehmungen aufweisen, die mit der Anordnung der Leiterbahnanschlüsse 212 korrespondieren. Beispielsweise können die in der kammartigen Struktur angeordneten Leiterbahnanschlüsse 212 mit in der Zeichnung nicht dargestellten Kabeln verlötet sein, die aus den Ausnehmungen der kammartigen Struktur und aus dem ebenfalls nicht dargestellten Gehäuse herausführen.

Das vorstehend zu der kammartigen Struktur der als Abstandsplatte ausgebildeten Leiterplatte 22 gilt auch für die der Einstecköffnung 15 gegenüberliegende kammartige Struktur der Leiterplatte 120 des ersten Steckverbinders 2, dessen seinem Steckbereich 15 gegenüberliegende Leiterbahnanschlüsse 112 über entsprechenden Ausnehmungen der kammartigen Struktur zugänglich sind. In diesem Zusammenhang wird hier erneut auf Fig. 4C verwiesen, wobei die weiteren Leiterplatten 130, 140 und 150 jeweils entsprechende vorstehend unter Bezugnahme auf Fig. 1A und B beschriebene Ausnehmungen 135, 145 und 155 aufweisen. Bei der Leiterplatte 160 handelt es sich um eine einfache Abdeckung, die auf der fünften Leiterplatte 150 angeordnet ist und zum besseren Verständnis in Fig. 3A und 3B nicht dargestellt ist.

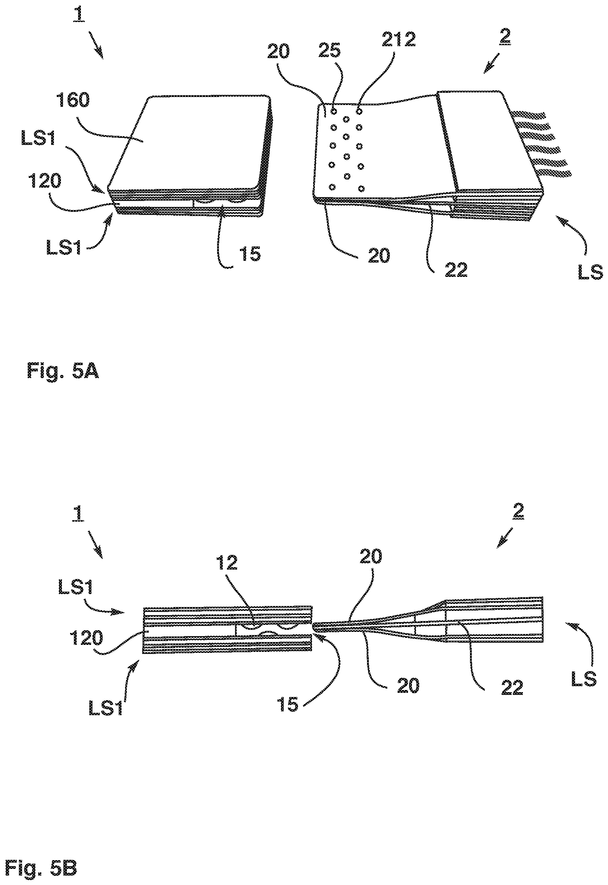

Fig. 5A zeigt eine perspektivische Darstellung eines ersten 1 und zweiten 2 Steckverbinders nach einer Ausführung der Erfindung und Fig. 5B zeigt eine Seitenansicht des ersten 1 und zweiten 2 Steckverbinders von Fig. 5A, wobei der Steckverbinder 2 an der Einstecköffnung 15 des korrespondierend mit dem Steckverbinder 1 von Fig. 3A und 3B ausgebildeten Steckverbinders 1, der anders als der Steckverbinder 1 von Fig. 3A und B an seinem Steckbereich 15 keine mechanische Kodierung aufweist und entsprechend dem Steckverbinder 2 von Fig. 5A und B eine Vielzahl von Leiterbahnanschlüssen 112 mit korrespondierenden Kontaktelementen 12 aufweist.

Der Steckverbinder 2 weist eine mittig in dem Leiterplatten-Stack LS angeordnete Leiterplatte 22 zur Beabstandung und Stabilisierung der mit den Leiterbahnanschlüssen 212 versehenen Leiterplatten 20, wobei die Leiterplatte 22 sandwichartig zwischen den Leiterplatten 20 angeordnet ist. Es ist klar, dass dabei die jeweils an den Leiterplatten 20 ausgebildeten Leiterbahnanschlüsse 212 derart angeordnet sind, dass sie in gestecktem Zustand von den Kontaktelementen 12 des Steckverbinders 1 kontaktierbar sind.

Wie die vorstehend beschrieben erste Leiterplatte 110 handelt es sich bei den Leiterplatten 20 um flexible Leiterplatten 20, die in dem Steckbereich des Steckverbinders 2 benachbart zueinander auf beiden Seiten der Leiterplatte 22 mit einem entsprechend geringen Abstand zueinander angeordnet sind, und die in dem mittels dem Leiterplatten-Stack LS bereitgestellten Gehäuse aus der Ebene ihres Steckbereichs heraus weiter voneinander beabstandet sind. Die Leiterbahnanschlüsse 212 der Leiterplatten 20 können wie in Fig. 5A dargestellt an der dem Steckbereich des Steckverbinders 2 gegenüberliegenden Seite mit Kabeln verlötet sein, die aus dem Gehäuse herausführen.

Mittels den wie vorstehend beschriebenen flexiblen und voneinander in dem Gehäuse beträchtlich beabstandet angeordneten Leiterplatten 20 kann alternativ an der dem Steckbereich gegenüberliegenden Seite des Steckverbinders 2 ein Steckverbinder 1 nach einer Ausführung der Erfindung bereitgestellt sein, der eine Einstecköffnung 15 aufweist, wobei der Leiterplatten-Stack LS ein vorstehend beschriebener erster und zweiter Leiterplatten-Stack LS1 sein kann, wobei mittels den flexiblen Leiterplatten 20 zwei erste Leiterplatten 110 bereitgestellt sein können.

Die Leiterbahnen der Leiterplatten 20 sind hier der Einfachheit und Übersichtlichkeit halber nicht dargestellt, wobei die Leiterbahnanschlüsse 212 auch in Steckrichtung und/oder senkrecht zur Steckrichtung redundant einer Leiterbahn und/oder mehreren Leiterbahnen zugeordnet sein können.

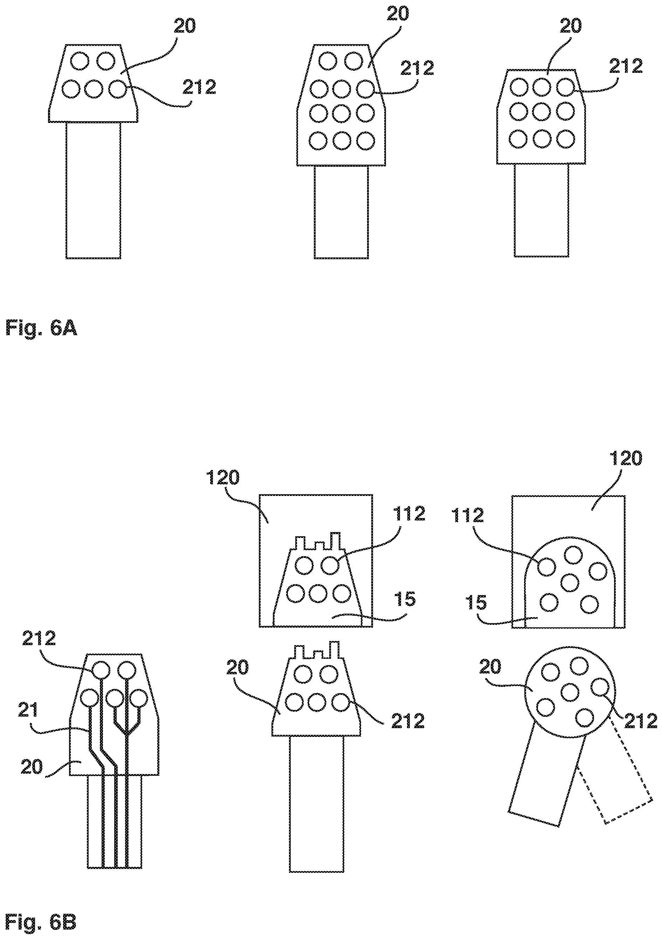

Fig. 6A zeigt schematische Darstellungen von Ausführungen eines Steckverbinders 2 nach einer Ausführung der Erfindung, und Fig. 6B zeigt schematische Darstellungen von Ausführungen eines ersten 1 und zweiten 2 Steckverbinders nach einer Ausführung der Erfindung, wobei jeweils zum besseren Verständnis lediglich die Leiterplatten 20 und/oder 120 zusammen mit Konturen von Steckbereichen 15 und Leiterbahnanschlüssen 112 dargestellt ist.

Anhand der schematisch dargestellten Ausführungen wird klar, wie ein Steckverbinder einer Ausführung der Erfindung insbesondere auch für viele Anwendungen wünschenswert modifiziert abgewandelt und optimiert werden kann.

Bei den zu kontaktierenden Leiterplatten 20 eines Steckverbinders 2 von Fig. 6A handelt es sich um jeweils mechanisch kodiert ausgebildete Leiterplatten, wobei die mittige Leiterplatte 20 vergleichsweise zu der rechten und linken Leiterplatte 20 beim Stecken in einen Steckverbinder 1 eine Mehrzahl an Funktionen aufweisen kann.

Die linke und rechte Leiterplatte 20 von Fig. 6A sind demgegenüber eingeschränkt und unterscheiden sich voneinander. Beispielsweise kann ein Steckverbinder 1 mit einer passenden Kodierung seines Steckbereichs 15 an einer Vorrichtung vorgesehen sein, wobei mittels der gesteckten rechten Leiterplatte 20 ein Prüfmodus der Vorrichtung bereitgestellt werden kann und mittels der linken Leiterplatte 20 ein Betriebsmodus der Vorrichtung bereitgestellt werden kann und mittels der mittleren Leiterplatte 20 ein Wartungsmodus oder Programmiermodus der Vorrichtung bereitgestellt sein kann.

Das vorstehend gesagte gilt auch für die linke und mittige Leiterplatte 20 von Fig. 6B, die beide mechanisch kodiert sind, wobei die linke Leiterplatte neben dem zu der mittigen Leiterplatte 20 passenden Steckbereich auch für weitere abgewandelte Kodierungen des Steckbereichs 15 geeignet ist, während die mittige Leiterplatte 20 nur zu dem über ihr dargestellten Steckbereich 15 passt. Dementsprechend können sich auch die Leiterbahnen 21 der linken und mittigen Leiterplatte 20 unterscheiden, wobei beispielhaft die linke Leiterplatte 20 eine Leiterbahn 21 mit drei redundanten Leiterbahnanschlüssen 212 aufweist.

Die rechte Leiterplatte 20 von Fig. 6A und der mit ihr korrespondierend mechanisch kodierte Steckbereich 15 weist sechs punktsymmetrisch angeordnete Leiterbahnanschlüsse 212 auf, wobei die Leiterplatte auf verschiedene Weise gedreht steckbar ist, wobei die unterschiedlichen Steckstellungen jeweils vorbestimmte unterschiedliche Funktionen einer Vorrichtung auslösen kann, an der eine entsprechend kontaktierter Steckverbinder 1 vorgesehen ist. Es ist klar, dass die rechte Leiterplatte 20 auch auf ihrer anderen Seite entsprechende Leiterbahnanschlüsse 212 aufweisen kann wobei die symmetrische Leiterplatte auch aus der Zeichenebene heraus gewendet in entsprechend gestecktem Zustand weitere Funktionen bereitstellen kann.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind.

### Bezugszeichenliste

- 1: Steckverbinder
- 110, 120, 130, 140, 150, 160, 170: (erste, zweite, dritte, vierte, fünfte, sechste, siebte) Leiterplatte
- 11: Leiterbahn
- 112: Leiterbahnanschluss
- 113: U-förmige Ausnehmung
- 115: Ausnehmung
- 12: Kontaktelement
- 13: Federelement, Blattfeder
- 135: Ausnehmung
- 145: Ausnehmung
- 15: Steckbereich, Ausnehmung
- 155: Ausnehmung

- 2: Steckverbinder
- 20: Leiterplatte
- 21: Leiterbahn
- 212: Leiterbahnanschluss
- 22: Leiterplatte
- 25: Ausnehmung
- 26: Rand, ringförmiges Kontaktelement

- LS, LS1: Leiterplatten-Stack
- K1, K2, K3, K4: (erste, zweite, dritte, vierte) Kunststoffplatte

## Patentansprüche

1. Steckverbinder (1),
zur Bereitstellung einer elektrischen Verbindung mit einem Leiterbahnanschluss (212) einer Leiterbahn (21) einer Leiterplatte (20), mit den Merkmalen:
der Steckverbinder (1) weist eine erste Leiterplatte (110) mit einem Leiterbahnanschluss (112) einer Leiterbahn (11) auf;
der Steckverbinder (1) weist einen Steckbereich (15) zum Stecken der Leiterplatte (20) in den Steckverbinder (1) auf;
der Steckbereich (15) erstreckt sich parallel zu der ersten Leiterplatte (110);
in dem Steckverbinder (1) ist ein Kontaktelement (12) vorgesehen; wobei
der Steckbereich (15) eine in einer zweiten Kunststoffplatte (K2; 120) ausgebildete Ausnehmung ist,
wobei in dem Steckverbinder (1) ist neben dem Kontaktelement (12) außerdem ein Federelement (13) vorgesehen, wobei
der Steckbereich (15) und das Kontaktelement (12) und das Federelement (13) derart ausgebildet und angeordnet sind, dass in einem gesteckten Zustand des Steckverbinders (1) die in den Steckbereich (15) gesteckte Leiterplatte (20) parallel zu der ersten Leiterplatte (110) angeordnet ist und der Leiterbahnanschluss (212) gegenüber dem Leiterbahnanschluss (112) angeordnet ist, und
über das Kontaktelement (12) und das Federelement (13) eine elektrische Verbindung des Leiterbahnanschlusses (112) mit dem Leiterbahnanschluss (212) bereitgestellt ist, und wobei die erste Leiterplatte (110) eine vorbestimmte Flexibilität aufweist, und das Federelement (13) einstückig mit der ersten Leiterplatte (110) ausgebildet ist, **gekennzeichnet, durch**
die zweite Kunststoffplatte sandwichartig zwischen einer ersten (K1; 170) und dritten Kunststoffplatte (K3; 130, 140) angeordnet ist; und wobei die erste Leiterplatte (110) auf der dritten Kunststoffplatte (K3; 130,140) angeordnet ist; und wobei auf der ersten Leiterplatte (110) eine vierte Kunststoffplatte (K4;150, 160) angeordnet ist, so dass eine Abdeckung der ersten Leiterplatte (110) bereitgestellt ist;
und wobei in der dritten Kunststoffplatte (K3; 130, 140) eine Ausnehmung (135, 145) zur Beherbergung des Kontaktelements (12) ausgebildet ist; und wobei
das Federelement (13) ein Blattfederelement (13) ist, das mittels einer in der ersten Leiterplatte (110) ausgebildeten U-förmigen Ausnehmung (113) bereitgestellt ist,
wobei die U-förmige Ausnehmung (113) das Federelement (13) umgibt und der Leiterbahnanschluss (112) auf dem Federelement (13) angeordnet ist, und wobei
der Leiterbahnanschluss (112) ein Rand einer in der ersten Leiterplatte (110) ausgebildeten Ausnehmung (115) ist; und
das Kontaktelement (12) eine mit dem Leiterbahnanschluss (112) zusammenwirkende Kontur aufweist; und wobei der Rand der Ausnehmung (115) kreisförmig ausgebildet ist und das Kontaktelement (12) kugelförmig ausgebildet ist; und wobei in der vierten Kunststoffplatte (K4; 150, 160) eine Ausnehmung (155) zur Beherbergung des ausgelenkten Federelements (13) ausgebildet ist.

2. Steckverbinder (1) nach Anspruch 1, wobei die
zweite Kunststoffplatte (K2; 120) von einer zweiten Leiterplatte (120) bereitgestellt ist; und
die dritte Kunststoffplatte (K3; 130, 140) von einer dritten (130) und vierten (140) Leiterplatte bereitgestellt ist, wobei
in der vierten Leiterplatte (140) eine Ausnehmung (145) ausgebildet ist und in der dritten Leiterplatte (130) eine gegenüber der
Ausnehmung (145) verjüngte Ausnehmung (135) ausgebildet ist, und wobei die Ausnehmung (135, 145) von der Ausnehmung (135) und der Ausnehmung (145) gebildet ist; und
die vierte Kunststoffplatte (K4; 150, 160) von einer fünften (150) und sechsten (160) Leiterplatte bereitgestellt ist, wobei die Ausnehmung (155) in der fünften Leiterplatte (150) ausgebildet ist; und
die dritte (130) und vierte (140) und erste (110) und fünfte (150) und sechste (160) Leiterplatte in dieser Reihenfolge übereinander angeordnet einen Leiterplatten-Stack (LS1) bilden, wobei
ein erster Leiterplatten-Stack (LS1) auf einer Seite der zweiten Leiterplatte (120) angeordnet ist, wobei
die erste Kunststoffplatte (K1; 170) von einer siebten Leiterplatte (170) oder einem zweiten Leiterplatten-Stack (LS1) bereitgestellt ist, der auf der anderen Seite der zweiten Leiterplatte (120) angeordnet ist.

3. Steckverbinder (1) nach Anspruch 2 mit einer Vielzahl von Leiterbahnen (11) und Leiterbahnanschlüssen (112) und Federelementen (13) und Kontaktelementen (12) und Ausnehmungen (135) und Ausnehmungen (145) und Ausnehmungen (113) und Ausnehmungen (115) und Ausnehmungen (155).

4. Steckverbinder (1) nach Anspruch 2 oder 3, wobei mittels der ersten (110), zweiten (120), dritten (130), vierten (140), fünften (150), sechsten (160) und siebten (170) Leiterplatte und/oder mittels der ersten (K1; 170), zweiten (K2; 120), dritten (K3; 130, 140) und vierten (K4; 150, 160) Kunststoffplatte und der ersten Leiterplatte (110) ein Gehäuse des Steckverbinders (1) bereitgestellt ist.

5. Steckverbinder (1) nach einem der Ansprüche 2 bis 4, wobei die erste Leiterplatte (110) mit elektrischen und/oder elektronischen Bauelementen bestückt ist, wobei in der dritten (K3; 130, 140) und/oder vierten (K4; 150, 160) Kunststoffplatte oder in der vierten (140) und/oder fünften (150) Leiterplatte Ausnehmungen zur Beherbergung der Bauelemente ausgebildet sind.

6. Steckverbinder (1) nach einem der Ansprüche 1 bis 5, wobei der Steckbereich (15) eine Innenkontur aufweist, mittels der eine Kodierung des Steckverbinders (1) bereitgestellt ist.

7. Steckverbinder (2),
zur Bereitstellung einer elektrischen Verbindung eines Leiterbahnanschlusses (212) einer Leiterplatte (20) mit einem Steckverbinder (1) nach einem der Ansprüche 1 bis d6, wobei der Steckverbinder (2) ein Gegensteckverbinder des Steckverbinders (1) ist, mit den Merkmalen:
die Leiterplatte (20) ist Bestandteil des Steckverbinders (2);
der Steckverbinder (2) weist ein Gehäuse mit wenigstens zwei Kunststoffplatten auf;
die Leiterplatte (20) ist sandwichartig zwischen den wenigstens zwei Kunststoffplatten angeordnet und ragt zum Einstecken in den Steckbereich (15) des Steckverbinders (1) aus dem Gehäuse des Steckverbinders (2) heraus;
der Leiterbahnanschluss (212) ist mittels einem Rand einer in der Leiterplatte (20) ausgebildeten Ausnehmung (25) bereitgestellt.

8. Steckverbinder (2) nach Anspruch 7, wobei das Gehäuse mittels einem Leiterplatten-Stack (LS) bereitgestellt ist.

9. Steckverbinder (2) nach Anspruch 7 oder 8, wobei mittels dem Leiterbahnanschluss (212) außerdem ein Rastelement zur Verrastung mit dem Steckverbinder (1) bereitgestellt ist.

10. Steckverbinder (2) nach einem der Ansprüche 7 bis 9, wobei
auf beiden Seiten der Leiterplatte (20) eine Leiterbahn (21) und ein Leiterbahnanschluss (212) ausgebildet ist;
oder
mit zwei Leiterplatten (20), die übereinander angeordnet zusammengesetzt sind, wobei deren mit einem Leiterbahnanschluss (212) versehene Seiten entgegengerichtet angeordnet sind.

11. Steckverbinder (2) nach einem der Ansprüche 7 bis 10 mit einer Vielzahl von Leiterbahnen (21) und Leiterbahnanschlüssen (212) und Ausnehmungen (25).

12. Steckverbinder (2) nach einem der Ansprüche 7 bis 11, wobei die Leiterplatte (20) mit elektrischen und/oder elektronischen Bauelementen bestückt ist, wobei in dem Gehäuse des Steckverbinders (2) Ausnehmungen zur Beherbergung der Bauelemente ausgebildet sind.

13. Steckverbinder (2) nach einem der Ansprüche 7 bis 12, wobei die Leiterplatte (20) eine Kontur aufweist mittels der eine Kodierung des Steckverbinders (2) bereitgestellt ist, wobei die Kontur mit der Innenkontur des Steckbereichs (15) des Steckverbinders (1) korrespondierend ausgebildet ist.

14. Leiterplatte, mit den Merkmalen:
an einem Rand der Leiterplatte ist wenigstens ein Steckverbinder (1) mit den Merkmalen des Steckverbinders (1) nach einem der Ansprüche 1 bis 6 oder wenigstens ein Steckverbinder (2) mit den Merkmalen des Steckverbinders (1) nach einem der Ansprüche 7 bis 14 ausgebildet, wobei die Leiterplatte einstückig mit der Leiterplatte (110) oder der Leiterplatte (20) ist.

## Claims

1. Plug connector (1)
for providing an electrical connection to a conductor track connection (212) of a conductor track (21) of a printed circuit board (20), having the features:
the plug connector (1) has a first printed circuit board (110) having a conductor track connection (112) of a conductor track (11);
the plug connector (1) has a mating area (15) for plugging the printed circuit board (20) into the plug connector (1);
the mating area (15) extends parallel to the first printed circuit board (110);
a contact element (12) is provided in the plug connector (1);
wherein
the mating area (15) is a cut-out that is embodied in a second synthetic material plate (K2; 120);
wherein
a spring element (13) is moreover provided next to the contact element (12) in the plug connector (1), wherein the mating area (15) and the contact element (12) and the spring element (13) are embodied and arranged in such a manner that in a plugged state of the plug connector (1) the printed circuit board (20) that is plugged into the mating area (15) is arranged parallel to the first printed circuit board (110), and the conductor track connection (212) is arranged opposite the conductor track connection (112); and
an electrical connection of the conductor track connection (112) to the conductor track connection (212) is provided by way of the contact element (12) and the spring element (13); and wherein
the first printed circuit board (110) has a predetermined amount of flexibility, and the spring element (13) is embodied as one piece with the first printed circuit board (110), **characterized by**
the second synthetic material plate being arranged in a sandwich-like manner between a first (K1; 170) and third synthetic material plate (K3; 130, 140);
and wherein the first printed circuit board (110) is arranged on the third synthetic material plate (K3; 130, 140); and wherein a fourth synthetic material plate (K4; 150, 160) is arranged on the first printed circuit board (110) with the result that a cover is provided on the first printed circuit board (110); and wherein
a cut-out (135, 145) for accommodating the contact element (12) is embodied in the third synthetic material plate (K3; 130, 140); and wherein
the spring element (13) is a leaf spring element (13) that is provided by means of a U-shaped cut-out (113) that is embodied in the first printed circuit board (110);
wherein the U-shaped cut-out (113) encompasses the spring element (13), and the conductor track connection (112) is arranged on the spring element (13); and wherein
the conductor track connection (112) is an edge of a cut-out (115) that is embodied in the first printed circuit board (110); and the contact element (12) has a contour that cooperates with the conductor track connection (112); and wherein
the edge of the cut-out (115) is embodied in a circular manner, and the contact element (12) is embodied in a spherical manner; and wherein
a cut-out (155) for accommodating the deflected spring element (13) is embodied in the fourth synthetic material plate (K4; 150, 160).

2. Plug connector (1) according to Claim 1, wherein the second synthetic material plate (K2; 120) is provided by a second printed circuit board (120); and
the third synthetic material plate (K3; 130, 140) is provided by a third (130) and fourth (140) printed circuit board, wherein
a cut-out (145) is embodied in the fourth printed circuit board (140), and a cut-out (135) that tapers with respect to the cut-out (145) is embodied in the third printed circuit board (130); and wherein the cut-out (135, 145) is formed by the cut-out (135) and the cut-out (145); and
the fourth synthetic material plate (K4; 150, 160) is provided by a fifth (150) and sixth (160) printed circuit board, wherein the cut-out (155) is embodied in the fifth printed circuit board (150); and
the third (130) and fourth (140) and first (110) and fifth (150) and sixth (160) printed circuit board arranged one above the other in this sequence form a printed circuit board stack (LS1), wherein
a first printed circuit board stack (LS1) is arranged on a side of the second printed circuit board (120), wherein
the first synthetic material plate (K1; 170) is provided by a seventh printed circuit board (170) or a second printed circuit board stack (LS1) that is arranged on the other side of the second printed circuit board (120).

3. Plug connector (1) according to Claim 2, having a plurality of conductor tracks (11) and conductor track connections (112) and spring elements (13) and contact elements (12) and cut-outs (135) and cut-outs (145) and cut-outs (113) and cut-outs (115) and cut-outs (155).

4. Plug connector (1) according to Claim 2 or 3, wherein a housing of the plug connector (1) is provided by means of the first (110), second (120), third (130), fourth (140), fifth (150), sixth (160) and seventh (170) printed circuit board, and/or by means of the first (K1; 170), second (K2; 120), third (K3; 130, 140) and fourth (K4; 150, 160) synthetic material plate and the first printed circuit board (110).

5. Plug connector (1) according to one of Claims 2 to 4, wherein the first printed circuit board (110) is populated with electrical and/or electronic components; wherein cut-outs for accommodating the components are embodied in the third (K3; 130, 140) and/or fourth (K4; 150, 160) synthetic material plate or in the fourth (140) and/or fifth (150) printed circuit board.

6. Plug connector (1) according to one of Claims 1 to 5, wherein the mating area (15) has an inner contour by means of which the plug connector (1) is provided with a coding.

7. Plug connector (2),
for providing an electrical connection of a conductor track connection (212) of a printed circuit board (20) to a plug connector (1) according to one of Claims 1 to 6, wherein the plug connector (2) is a mating connector of the plug connector (1), having the features:
the printed circuit board (20) is a component of the plug connector (2);
the plug connector (2) has a housing having at least two synthetic material plates;
the printed circuit board (20) is arranged in a sandwich-like manner between the at least two synthetic material plates and protrudes out of the housing of the plug connector (2) so as to plug into the mating area (15) of the plug connector (1);
the conductor track connection (212) is provided by means of an edge of a cut-out (25) that is embodied in the printed circuit board (20).

8. Plug connector (2) according to Claim 7, wherein
the housing is provided by means of a printed circuit board stack (LS).

9. Plug connector (2) according to Claim 7 or 8, wherein moreover provided by means of the conductor track connection (212) is a latching element to latch with the plug connector (1).

10. Plug connector (2) according to one of Claims 7 to 9, wherein a conductor track (21) and a conductor track connection (212) are embodied on both sides of the printed circuit board (20);
or
having two printed circuit boards (20) that are assembled arranged one above the other, wherein their sides that are provided with a conductor track connection (212) are arranged opposite one another.

11. Plug connector (2) according to one of Claims 7 to 10, having a plurality of conductor tracks (21) and conductor track connections (212) and cut-outs (25).

12. Plug connector (2) according to one of Claims 7 to 11, wherein the printed circuit board (20) is populated with electrical and/or electronic components, wherein cut-outs for accommodating the components are embodied in the housing of the plug connector (2).

13. Plug connector (2) according to one of Claims 7 to 12, wherein the printed circuit board (20) has a contour by means of which the plug connector (2) is provided with a coding, wherein the contour is embodied so as to correspond with the inner contour of the mating area (15) of the plug connector (1).

14. Printed circuit board, having the features:
embodied on an edge of the printed circuit board is at least one plug connector (1) having the features of the plug connector (1) according to one of Claims 1 to 6, or at least one plug connector (2) having the features of the plug connector (1) according to one of Claims 7 to 14, wherein the printed circuit board is one piece with the printed circuit board (110) or the printed circuit board (20).

## Revendications

1. Connecteur enfichable (1),
servant à produire une connexion électrique avec une borne de tracé conducteur (212) d'un tracé conducteur (21) d'une carte de circuit imprimé (20), présentant les caractéristiques suivantes :
le connecteur enfichable (1) présente une première carte de circuit imprimé (110) comportant une borne de tracé conducteur (112) d'un tracé conducteur (11) ;
le connecteur enfichable (1) présente une zone d'enfichage (15) servant à l'enfichage de la carte de circuit imprimé (20) dans le connecteur enfichable (1) ;
la zone d'enfichage (15) s'étend parallèlement à la première carte de circuit imprimé (110) ;
un élément de contact (12) est prévu dans le connecteur enfichable (1) ;
la zone d'enfichage (15) étant un évidement réalisé dans une deuxième plaque en matière synthétique (K2 ; 120),
un élément ressort (13) étant en outre prévu à côté de l'élément de contact (12) dans le connecteur enfichable (1), la zone d'enfichage (15) et l'élément de contact (12) et l'élément ressort (13) étant réalisés et disposés de telle sorte que, dans un état enfiché du connecteur enfichable (1), la carte de circuit imprimé (20) enfichée dans la zone d'enfichage (15) est disposée parallèlement à la première carte de circuit imprimé (110) et la borne de tracé conducteur (212) est disposée en regard de la borne de tracé conducteur (112), et
une connexion électrique de la borne de tracé conducteur (112) avec la borne de tracé conducteur (212) étant produite par le biais de l'élément de contact (12) et de l'élément ressort (13), et
la première carte de circuit imprimé (110) présentant une flexibilité prédéfinie, et l'élément ressort (13) étant réalisé d'une seule pièce avec la première carte de circuit imprimé (110), **caractérisé en ce que**
la deuxième plaque en matière synthétique est disposée à la manière d'un sandwich entre une première (K1 ; 170) et une troisième plaque en matière synthétique (K3 ; 130, 140) ; et la première carte de circuit imprimé (110) étant disposée sur la troisième plaque en matière synthétique (K3 ; 130, 140) ; et une quatrième plaque en matière synthétique (K4 ;150, 160) étant disposée sur la première carte de circuit imprimé (110), de sorte qu'un recouvrement de la première carte de circuit imprimé (110) soit produit ;
et un évidement (135, 145) servant au logement de l'élément de contact (12) étant réalisé dans la troisième plaque en matière synthétique (K3 ; 130, 140) ; et
l'élément ressort (13) étant un élément ressort à lame (13) qui est produit au moyen d'un évidement (113) en forme de U réalisé dans la première carte de circuit imprimé (110),
l'évidement (113) en forme de U entourant l'élément ressort (13) et la borne de tracé conducteur (112) étant disposée sur l'élément ressort (13), et
la borne de tracé conducteur (112) étant un bord d'un évidement (115) réalisé dans la première carte de circuit imprimé (110) ; et
l'élément de contact (12) présentant un contour coopérant avec la borne de tracé conducteur (112) ; et
le bord de l'évidement (115) étant réalisé de manière circulaire et l'élément de contact (12) étant réalisé de manière sphérique ; et
un évidement (155) servant au logement de l'élément ressort (13) défléchi étant réalisé dans la quatrième plaque en matière synthétique (K4 ; 150, 160).

2. Connecteur enfichable (1) selon la revendication 1, la deuxième plaque en matière synthétique (K2 ; 120) étant produite par une deuxième carte de circuit imprimé (120) ; et
la troisième plaque en matière synthétique (K3 ; 130, 140) étant produite par une troisième (130) et une quatrième (140) carte de circuit imprimé,
un évidement (145) étant réalisé dans la quatrième carte de circuit imprimé (140) et un évidement (135) rétréci par rapport à l'évidement (145) étant réalisé dans la troisième carte de circuit imprimé (130), et l'évidement (135, 145) étant formé par l'évidement (135) et l'évidement (145) ; et
la quatrième plaque en matière synthétique (K4 ; 150, 160) étant produite par une cinquième (150) et une sixième (160) carte de circuit imprimé, l'évidement (155) étant réalisé dans la cinquième carte de circuit imprimé (150) ; et
la troisième (130) et la quatrième (140) et la première (110) et la cinquième (150) et la sixième (160) carte de circuit imprimé formant un empilement de cartes de circuit imprimé (LS1) de manière superposée dans cet ordre,
un premier empilement de cartes de circuit imprimé (LS1) étant disposé d'un côté de la deuxième carte de circuit imprimé (120),
la première plaque en matière synthétique (K1 ; 170) étant produite par une septième carte de circuit imprimé (170) ou un deuxième empilement de cartes de circuit imprimé (LS1), qui est disposé de l'autre côté de la deuxième carte de circuit imprimé (120).

3. Connecteur enfichable (1) selon la revendication 2, comportant une pluralité de tracés conducteurs (11) et de bornes de tracés conducteurs (112) et d'éléments ressorts (13) et d'éléments de contact (12) et d'évidements (135) et d'évidements (145) et d'évidements (113) et d'évidements (115) et d'évidements (155).

4. Connecteur enfichable (1) selon la revendication 2 ou 3, un boîtier du connecteur enfichable (1) étant produit au moyen de la première (110), de la deuxième (120), de la troisième (130), de la quatrième (140), de la cinquième (150), de la sixième (160) et de la septième (170) carte de circuit imprimé et/ou au moyen de la première (K1 ; 170), de la deuxième (K2 ; 120), de la troisième (K3 ; 130, 140) et de la quatrième (K4 ; 150, 160) plaque en matière synthétique et de la première carte de circuit imprimé (110).

5. Connecteur enfichable (1) selon l'une des revendications 2 à 4, la première carte de circuit imprimé (110) étant garnie de composants électriques et/ou électroniques, des évidements servant au logement des composants étant réalisés dans la troisième (K3 ; 130, 140) et/ou la quatrième (K4 ; 150, 160) plaque en matière synthétique ou dans la quatrième (140) et/ou la cinquième (150) carte de circuit imprimé.

6. Connecteur enfichable (1) selon l'une des revendications 1 à 5, la zone d'enfichage (15) présentant un contour intérieur au moyen duquel un codage du connecteur enfichable (1) est produit.

7. Connecteur enfichable (2),
servant à produire une connexion électrique d'une borne de tracé conducteur (212) d'une carte de circuit imprimé (20) avec un connecteur enfichable (1) selon l'une des revendications 1 à 6, le connecteur enfichable (2) étant un connecteur enfichable homologue du connecteur enfichable (1), présentant les caractéristiques suivantes :
la carte de circuit imprimé (20) fait partie du connecteur enfichable (2) ;
le connecteur enfichable (2) présente un boîtier comportant au moins deux plaques en matière synthétique ;
la carte de circuit imprimé (20) est disposée à la manière d'un sandwich entre les au moins deux plaques en matière synthétique et fait saillie hors du boîtier du connecteur enfichable (2) pour l'enfichage dans la zone d'enfichage (15) du connecteur enfichable (1) ;
la borne de tracé conducteur (212) est produite au moyen d'un bord d'un évidement (25) réalisé dans la carte de circuit imprimé (20).

8. Connecteur enfichable (2) selon la revendication 7, le boîtier étant produit au moyen d'un empilement de cartes de circuit imprimé (LS).

9. Connecteur enfichable (2) selon la revendication 7 ou 8,
un élément d'encliquetage servant à l'encliquetage avec le connecteur enfichable (1) étant produit en outre au moyen de la borne de tracé conducteur (212).

10. Connecteur enfichable (2) selon l'une des revendications 7 à 9,
un tracé conducteur (21) et une borne de tracé conducteur (212) étant réalisés des deux côtés de la carte de circuit imprimé (20) ;
ou
avec deux cartes de circuit imprimé (20), qui sont assemblées de manière superposée, leurs côtés dotés d'une borne de tracé conducteur (212) étant disposés de manière opposée.

11. Connecteur enfichable (2) selon l'une des revendications 7 à 10, comportant une pluralité de tracés conducteurs (21) et de bornes de tracés conducteurs (212) et d'évidements (25).

12. Connecteur enfichable (2) selon l'une des revendications 7 à 11, la carte de circuit imprimé (20) étant garnie de composants électriques et/ou électroniques, des évidements servant au logement des composants étant réalisés dans le boîtier du connecteur enfichable (2).

13. Connecteur enfichable (2) selon l'une des revendications 7 à 12, la carte de circuit imprimé (20) présentant un contour au moyen duquel un codage du connecteur enfichable (2) est produit, le contour étant réalisé de manière à correspondre au contour intérieur de la zone d'enfichage (15) du connecteur enfichable (1).

14. Carte de circuit imprimé, présentant les caractéristiques suivantes :
au niveau d'un bord de la carte de circuit imprimé est réalisé au moins un connecteur enfichable (1) présentant les caractéristiques du connecteur enfichable (1) selon l'une des revendications 1 à 6 ou au moins un connecteur enfichable (2) présentant les caractéristiques du connecteur enfichable (1) selon l'une des revendications 7 à 14, la carte de circuit imprimé étant d'une seule pièce avec la carte de circuit imprimé (110) ou la carte de circuit imprimé (20).
